(19) Europäisches Patentamt
European Patent Office
Office européen des brevets

(11) **EP 2 413 347 A1**

(12) **EUROPEAN PATENT APPLICATION**

(43) Date of publication:
**01.02.2012 Bulletin 2012/05**

(51) Int Cl.:
***H01L 21/02*** (2006.01)  ***H01L 23/522*** (2006.01)
***H01L 27/02*** (2006.01)

(21) Application number: **10290414.1**

(22) Date of filing: **28.07.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **NXP B.V.**
**5656 AG Eindhoven (NL)**

(72) Inventor: **Kala, Saleem**
**14906 Caen (FR)**

(74) Representative: **Schouten, Marcus Maria**
**NXP B.V.**
**IP & Licensing Department**
**High Tech Campus 60**
**5656 AG Eindhoven (NL)**

(54) **Fringe capacitor based on fractal patterns**

(57)     Disclosed is an integrated circuit that comprises a first capacitive structure (500) including a first electrode (510) characterized by a plurality of series coupled conductive line segments arranged in a fractal pattern in a first layer of the integrated circuit. A second electrode (520) in the first layer of the integrated circuit has a shape bounded by and conductively isolated from the first electrode.

FIG. 3

EP 2 413 347 A1

**Description**

FIELD OF INVENTION

This invention relates to integrated circuit processing of capacitive structures. More particularly, this invention relates to a MOM (Metal Oxide Metal) capacitor architecture based on fractal patterns, to improve the capacitance density without impacting the ESR (Estimated Serial Resistance) and ESL (Estimated Serial Inductance).

BACKGROUND OF THE INVENTION

The electronics industry continues to rely upon advances in semiconductor technology to realize higher-function devices in more compact areas. For many applications realizing higher-functioning devices requires integrating a large number of electronic devices into a single silicon wafer. As the number of electronic devices per given area of the silicon wafer increases, the manufacturing process becomes more difficult.

Many varieties of semiconductor devices have been manufactured having various applications in numerous disciplines. Such silicon-based semiconductor devices often include metal-oxide-semiconductor field-effect transistors (MOSFET), such as p-channel MOS (PMOS), n-channel MOS (NMOS) and complementary MOS (CMOS) transistors, bipolar transistors, BiCMOS transistors. Such MOSFET devices include an insulating material between a conductive gate and silicon-like substrate; therefore, these devices are generally referred to as IGFETs (insulated-gate FET).

Each of these semiconductor devices generally includes a semiconductor substrate on which a number of active devices are formed. The particular structure of a given active device can vary between device types. For example, in MOS transistors, an active device generally includes source and drain regions and a gate electrode that modulates current between the source and drain regions.

Furthermore, such devices may be digital or analog devices produced in a number of wafer fabrication processes, for example, CMOS, BiCMOS, Bipolar, *etc.* The substrates may be silicon, gallium arsenide (GaAs) or other substrate suitable for building microelectronic circuits thereon.

Of particular importance, in the fabrication of semiconductor devices, is the forming of capacitive structures. In high-performance mixed signal devices, as the critical dimensions get ever smaller, such as those in the deep sub-micron realm, maximizing the fringe capacitor and plate capacitor structure becomes significant. These capacitors are used for low frequency (LF) decoupling, radio frequency (RF) decoupling with a high quality factor, alternating current (AC) coupling or filtering.

One approach for providing capacitance involves interleaving thin metal tracks on one or more stacked layers. This is used in advanced CMOS technologies, where the thickness of the metal tracks is greater than the width. In another approach, when multiple layers are involved, superimposed patterns are shifted to benefit from a capacitive effect in the vertical direction as well as horizontal direction. The elongated shape of the capacitor's fingers may cause the series resistance of the capacitor to be higher than desired. In addition, the layout of these two capacitor structures makes access to components placed underneath (e.g., a MOS capacitor or other device) more challenging. Finally, in deep sub micron CMOS, due to manufacturing constraints, the length of the metal fingers is limited, thus limiting the size of the capacitance.

Owing to the shortcomings of these capacitor structures, there exists a need for a capacitor structure that provides increased capacitance in a minimized space.

SUMMARY OF INVENTION

In applications of high performance devices, there is a need for passive component structures of sufficient value to complement the active structures designed and implemented. By use of a fractal geometry, the Hilbert curve, the present disclosure provides for capacitive structures of increased unit capacitance in a reduced layout area and is compatible with modem sub-micron fabrication technology. A modem fabrication technology typically has multiple metal layers and as such, provides flexibility in implementing said invention. Furthermore, the Hilbert capacitive structure finds a specific use in differential circuit applications.

In an example embodiment, an integrated circuit (IC) comprises, a first capacitive structure including a first electrode characterized by a plurality of series coupled conductive line segments arranged in a fractal pattern in, a first layer of the integrated circuit. A second electrode in the first layer of the integrated circuit, the second electrode has a shape bounded by and conductively isolated from the first electrode.

In another example embodiment, there is a Hilbert fractal pattern capacitive structure in an integrated circuit (IC) device. The capacitive structure comprises a first electrode defined by the Hilbert fractal pattern of at one iteration. A second electrode of has a shape bounded by and conductively isolated from the first electrode. The first and second electrodes define the capacitive structure. A feature of this embodiment is that dimensions of the capacitive structures may be governed by the critical dimensions of the manufacturing process. Furthermore, the at least one iteration may also be governed by critical dimensions of the manufacturing process, as well.

In yet another example embodiment, a Hilbert fractal capacitor unit cell comprises four Hilbert fractal pattern capacitive structures. The fractal capacitive structure includes a first capacitive structure manufactured on a thin first metal layer at a first orientation; the Hilbert fractal capacitive structure has a first electrode defined by a Hilbert fractal pattern of at least one iteration. A second electrode has a shape bounded by and conductively isolated from the first electrode. There is an inter-level dielectric covering the thin first metal layer, the inter-level dielectric having vias at a plurality locations on the first metal layer. An additional Hilbert fractal pattern capacitive structure is manufactured on an additional thin metal layer at an orientation rotated 90º counter-clockwise with respect to the first orientation; the additional metal layer connected to the first metal layer at the plurality of via locations, thereby connecting the first capacitive structure with the additional capacitive structure; a total capacitance of the fractal capacitive structure being present at the first electrode and second electrode..Each each fractal capacitive structure is oriented at 0°, 90°, 180°, and 270°, respectively with one another; and each oriented fractal capacitive structure is electrically coupled to one another, at the first and second electrodes, respectively, thereby a sum of each of the four fractal capacitive structures is the capacitance of the unit cell. A feature of this embodiment includes a first thick metal layer and a second thick metal layer separated by an inter-metal dielectric layer. The first and second thick metal layers are coupled together through vias at selected regions defining the first electrode and second electrode of the Hilbert fractal capacitor unit cell.

In an example embodiment, there is a third-iteration Hilbert fractal pattern capacitive structure. The structure comprises, capacitive structures manufactured on odd metal layers at a first orientation. An inter-level dielectric covers the odd metal layers, the inter-level dielectric has vias at a plurality of locations on the odd metal layer. Additional capacitive structures are manufactured on even metal layers at an orientation rotated 90° counter-clockwise with respect to the first orientation; the additional capacitive structure in the even metal layer are connected to the odd metal layers at the plurality of via locations, thereby connecting the capacitive structures with the additional capacitive structures.

In another example embodiment, an elementary third iteration Hilbert fractal pattern capacitive structure is configured as two capacitors. The capacitive structure comprises, a first electrode defined by a Hilbert fractal pattern of at least one iteration; and a second electrode having a shape bounded by and conductively isolated from the first electrode. At a pre-determined location, the first electrode is separated at so as to make two substantially identical additional electrodes. The resulting structure is two separate capacitors sharing a common electrode and each having an additional electrode. This as two capacitor structure may be configured so that the capacitance may be varied which is finds application in differential circuits.

In yet another example embodiment, there is method of manufacturing an integrated circuit having a Hilbert fractal elementary cell. The method comprises patterning a first Hilbert capacitive structure on a thin first metal layer at a first orientation, the Hilbert fractal pattern capacitive structure having, a first electrode defined by a Hilbert fractal pattern of at least one iteration; and a second electrode having a shape bounded by and conductively isolated from the first electrode. An inter-level dielectric covering the thin first metal layer is patterned; the inter-level dielectric has vias at a plurality of locations on the first metal layer. An additional Hilbert fractal pattern capacitive structure is patterned on an additional thin metal layer at an orientation rotated 90º counter-clockwise with respect to the first orientation; the additional metal layer is connected to the first metal layer at the plurality via locations, thereby connecting the first capacitive structure with the additional capacitive structure, a total capacitance of the fractal capacitive structure being present at the first electrode and second electrode.

The above summaries of the present invention are not intended to represent each disclosed embodiment, or every aspect, of the present invention. Other aspects and example embodiments are provided in the figures and the detailed description that follow.

## BRIEF DESCRIPTION OF THE DRAWINGS

The invention may be more completely understood in consideration of the following detailed description of various embodiments of the invention in connection with the accompanying drawings, in which:

Fig. 1 depicts the capacitance v. spacing relationship for an example fringe capacitor;
Fig. 2 depicts six iterations of the Hilbert fractal as applied to embodiments according to the present invention;
Fig.. 3 in an example embodiment according to the present invention, depicts the two electrodes of an elementary fractal capacitor according to an embodiment of the present invention;
Fig.. 4 in another example embodiment according to the present invention depicts a five metal layer stack of the elementary fractal capacitor, note that this elementary fractal capacitor cell stops at the third iteration of the Hilbert curve (as described in Fig.. 2);
Fig.. 5 depicts the five metal layer stack of FIG. 4 but showing illustrative via connections;
Fig.. 6 depicts a unit capacitor built of four elementary fractal capacitor cells of FIG. 5;

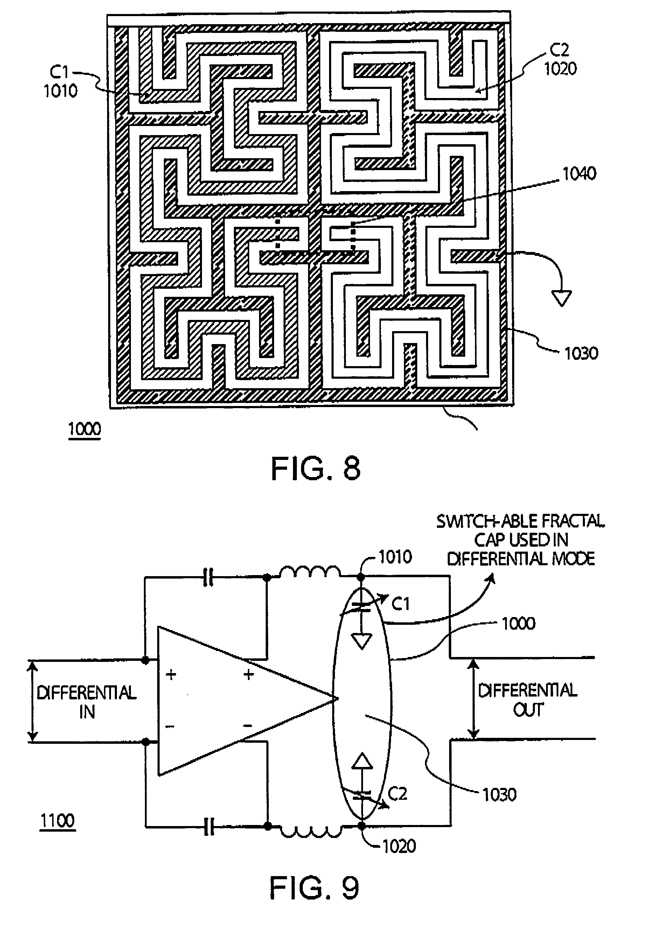

Fig.. 7 depicts the unit capacitor of FIG. 8 with metal layer 6 and metal layer 7;

Fig.. 8 another example embodiment according to the present invention, a dual capacitor structure; and

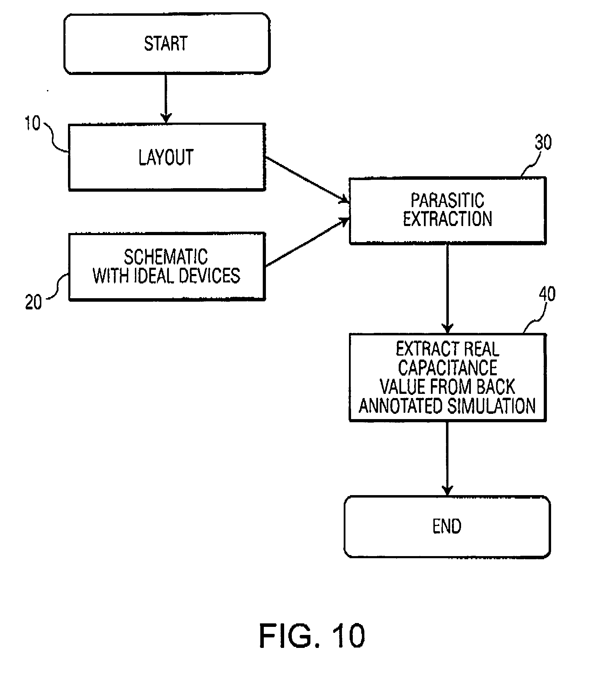

Fig. 9 depicts an application of the capacitor of Fig. 10 in a differential circuit; and

Fig.. 10 is a flowchart of an example design flow incorporating the described invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the spirit and scope of the invention as defined by the appended claims.

DETAILED DESCRIPTION OF THE INVENTION

In modern CMOS processes the very high resolution in metal layer etching results in a minimum feasible (or allowed) distance between two metal tracks from a same layer that is significantly smaller than the dielectric thickness separating two successive metal layers. The Inventor has found that for certain embodiments, this distance which order of magnitude is $0.1\,\mu m$, makes attractive the use of the so-called fringe capacitors that are referred to as lateral capacitors because the ratio between lateral distance and metal thickness is smaller than one (e.g., 1:3).

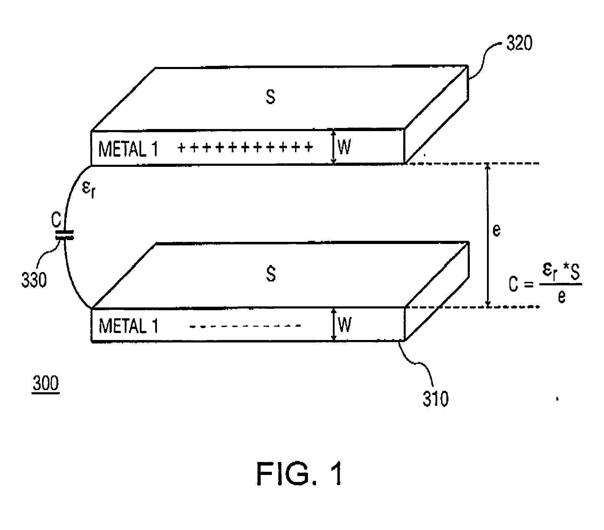

Refer to Fig. 1. A structure 300, generically illustrates for obtaining the largest fringe capacitor, in the case of only a single metal layer being available, when two metal lines 310, 320 are spaced minimally. The two adjacent metal lines 310, 320 are at a distance e apart and are of an area S (the length of the metal line times its thickness). Equation 1 describes the capacitance of the basic structure 300. In modern deep sub-micron technologies, the two lines cannot be longer than a certain length owing to limitations in the manufacturing process (i.e., during chemical mechanical polishing an extended length line may not adhere sufficiently to the substrate surface and be undesirably removed). In a CMOS Damascene processes, for example in CMOS 130nm and smaller, long metal length may be problematic.

$$C = \frac{\varepsilon_r}{e} \bullet S,$$

$$(1)$$

where

    S = area of metal line

    $\varepsilon_r$ = dielectric constant

    e = distance between two metal lines

The present invention has been found useful in implementing fringe capacitors based on a fractal pattern. A fractal pattern may be characterized as a geometrical or physical structure having an irregular or fragmented shape at all scales of measurement between a greatest and smallest scale such that certain mathematical or physical properties of the structure, as the perimeter of a curve or the flow rate in a porous medium, behave as if the dimensions of the structure (fractal dimensions) are greater than the spatial dimensions. For example, a dedicated fractal pattern resource, such as the Hilbert curve, provides the longest perimeter between two lines, in a minimized space. Other fractal-pattern resources may be used, as well (e.g., customized fractal-patterns and modifications of Hilbert-based fractal-patterns).

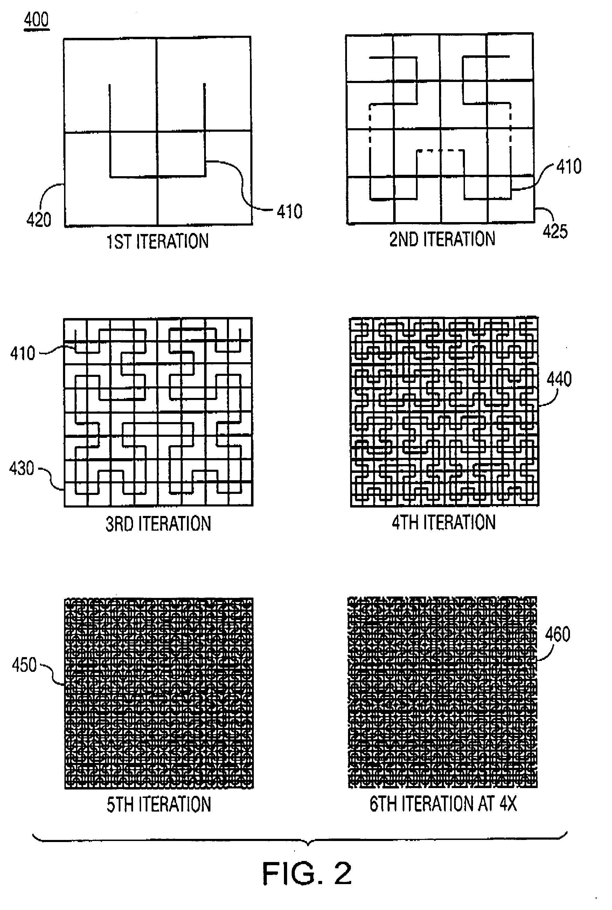

Using the Hilbert pattern 410, as in Fig. 2, a pattern 410 begins with a basic staple-like shape (mapped on a grid 420 for clarity) for the first iteration. In a second iteration, the previous curve is shrunk to half its size. Simultaneously, the grid size 420 is decreased by a factor of two. Four copies of the curve are placed on the grid. The lower two patterns 410 must be placed directly as they are. The upper two must be rotated 90 degrees, one counter-clockwise, the other clockwise. Lastly, the four copies of the curve are connected by short straight line segments to obtain the next order curve. The connecting line segments may either be vertical or horizontal. The process continues for the third, and subsequent iterations. In Fig. 2, six iterations of the Hilbert fractal are shown. This process of constructing the Hilbert curve is known as the Lindenmayer System (L-System).

As applied to a modem sub-micron process, the exemplifying Hilbert fractal only includes straight lines drawn at right angles, therefore may be readily manufactured. The degree of iteration would be limited by the minimum line width (i.e., "critical dimension (CD)") of the manufacturing process. These limits are expressed as "design rules" during the translation of the circuit schematic into a layout format. Such design rules, for example, include the minimum line widths and lengths at which a feature may be rendered, such features may include metallization, via width (i.e., connectors between two different metal layers), etc. The layout format ultimately defines the patterns imaged onto the masks which are then "printed" onto the silicon substrate, such patterns making the integrated circuit.

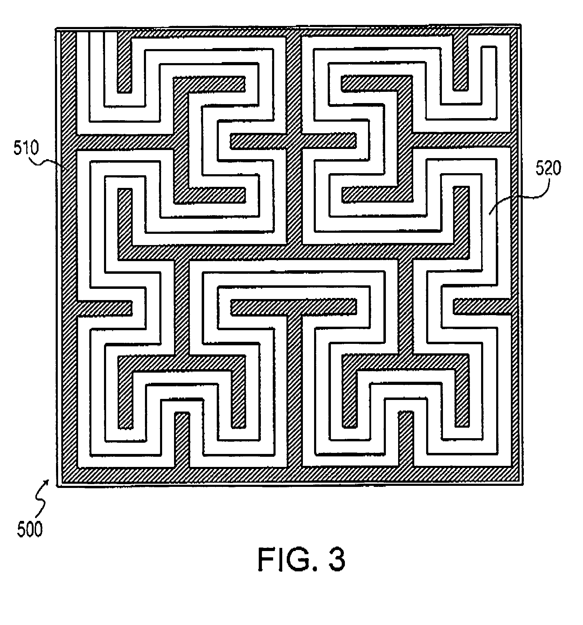

With reference to Fig. 3, in an example capacitor structure 500, shows two electrodes 510 and 520 made on the same metal layer. The electrodes are continuous and provide the maximum surface area on the perimeter side. In an example process (i.e., a "Manhattan" CMOS 45nm) the depth of the metal track is larger than the width; the maximum capacitance is from the perimeter side. However, in other more modern CMOS processes, there are multiple metal layers separated by inter-metal dielectric.

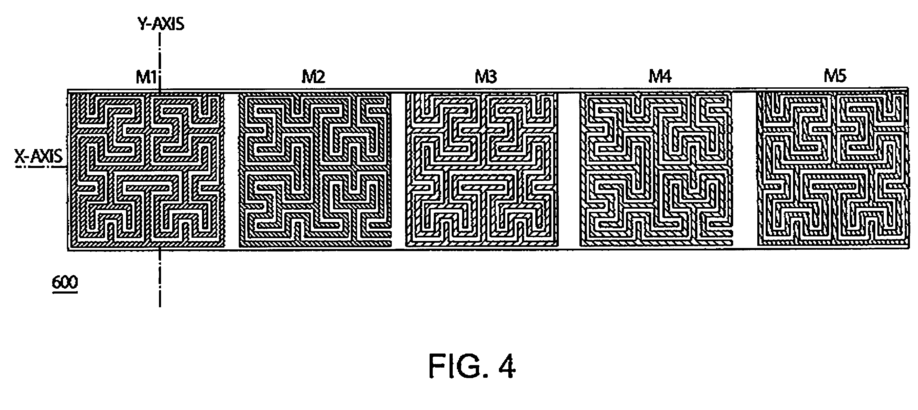

In the example CMOS 45nm process, there are seven metal layers. The first five layers are "thin" layers, Metal 1- 5, and the remaining two are "thick" metal layers, Metal 6-7. Refer to Fig. 4. The metal stack 600 of the elementary fractal capacitor is built in the five metal layers. The construction of the capacitor benefits from the "charge accumulation effect" on the numerous vertices, and in each metal layer. Metal layers 1, 3, and 5 are oriented in the same direction. Metal layers 2 and 4 are rotated counter-clockwise 90° and mirrored along the Y-axis. The re-orientation of Metal layers 2 and 4 further increases the capacitance by creating vertical plate capacitors which add to the fringe capacitance. An inter-metal dielectric separates each metal layer.

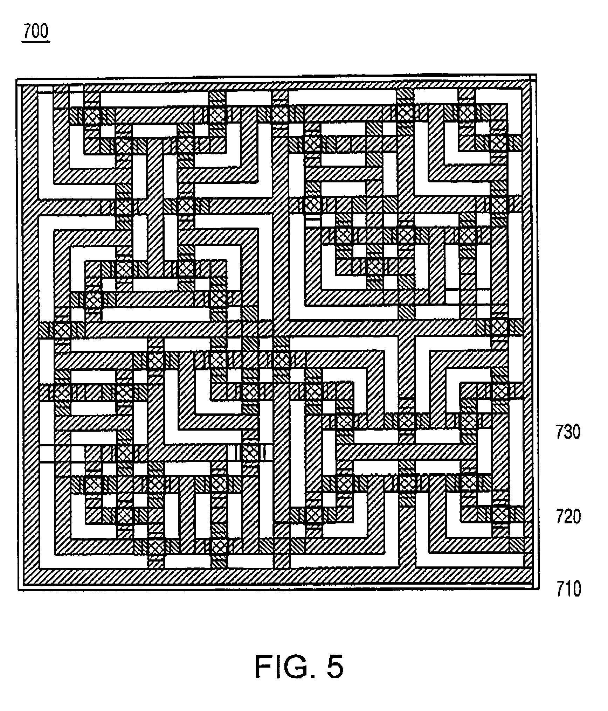

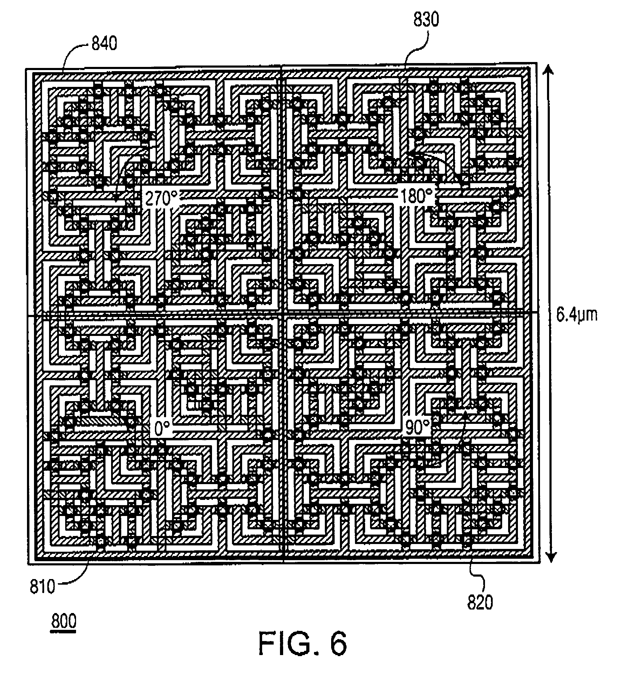

The two electrodes of the capacitor are present on each metal layer, and therefore must be connected together across all the metal layers. This can be done on the edges, however, the ESR and ESL will be impacted. To avoid this, the electrodes are connected through the inter-metal dielectric, using vias. These are placed across the unit cell so as to decrease the series resistance and in such a way to avoid any short circuit. Refer to Fig. 5. Capacitor structure 700 depicts the Metal 5 layer 710, the inter-metal dielectric layer ("via" layer) 720, and the Metal 4 layer 730. For the example process, the resulting structure is an elementary capacitor cell. For use in circuit applications, four of these elementary capacitor cells are combined to form a "unit cell" fractal capacitor. Refer to Fig. 6. The elementary capacitor cell of Fig. 5 forms the unit cell structure 800. A first elementary cell 810 is oriented at 0°, a second elementary cell 820 is oriented at 90° ,a third elementary cell is oriented at 180°, and a fourth elementary cell 840 is oriented at 270°; all four elementary cells are then electrically coupled to one another, thus forming the unit cell. For an example sub-micron process the length of the unit cell is about 6.4$\mu$m.

The unit cell 800 for a given design/process flow is the smallest capacitor that is defined for a given process that may be manufactured and is the base of a parameterized cell that is used to build any size capacitor greater than a unit cell. In addition, the resistance and inductance of each electrode is low in that the connection makes use of all the metal layers. The capacitance contribution comes from the depth of the device as well as its length.

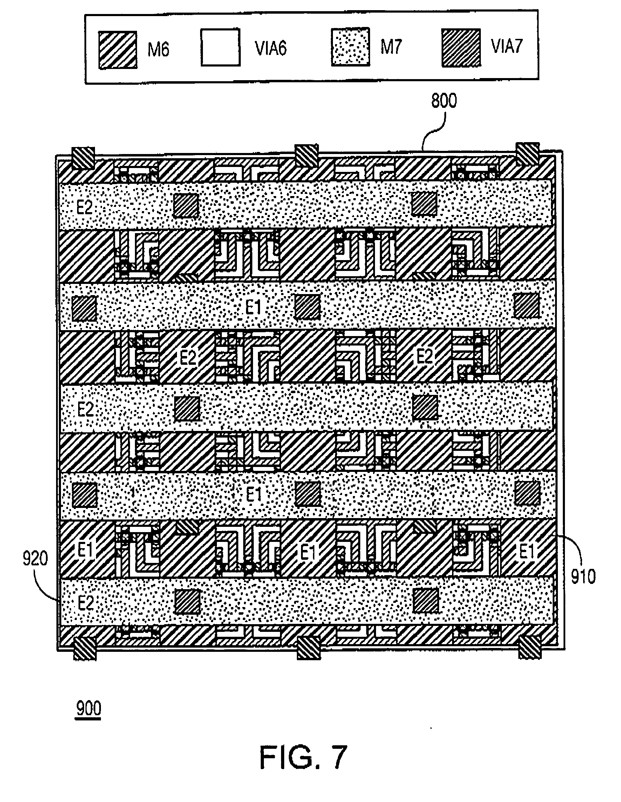

Refer to Fig. 7. To further decrease the ESL and ESR an alternate finger capacitor constructed from the Metal 6 (910) and Metal 7 (920) layers is placed above the fractal capacitor 800. The electrodes E1 and E2 are defined through the Via 6 and Via 7 connections.

In an example embodiment) the top metal layers (M7) may be used as a shield connected to a filtered voltage so as to mitigate noise and Electromagnetic Emission.

In another example embodiment, the lower metal layers can be omitted so as to decrease the parasitic capacitance to the substrate further. Indeed, the parasitic capacitance to the substrate is a inversely proportional to the distance of the bottom metal layer, to the substrate. When this distance is increased the parasitic capacitance is decreased, refer to Equation (1). To increase the distance, the bottom metal layer can be removed; although this impacts negatively the overall density of the capacitor, the parasitic capacitance to substrate is reduced as well. Per design requirements and objectives, compromises have to be made between these parameters.

Refer to Fig. 9. In another example embodiment, an elementary device 1000 may be derived from the elementary device of Fig 3. At 1040, the elementary fractal capacitor is split into two separate capacitive structures C1 (1010), and C2 (1020) at a location 1040. Two identical electrodes 1010, 1020 are enclosed by a common electrode 1030. The device 1000 is particularly suited for differential applications as shown in Fig. 9. To build this dual capacitor, the two electrode device is converted into a three electrode device. One electrode (1030 is common to both capacitors (in Fig. 8 this electrode is connected to a ground, but it can be any voltage).

The remaining two electrodes are then each an electrode for each capacitor. Therefore the two capacitors are identical and are referenced to the same third electrode. 1020 and 1010 are derived from metal line 510 of Fig. 3.

For an example sub-micron process, in the device described in Fig. 3, a comparison was made among two other example capacitors. Using a CADENCE (Electronic Design Automation products of Cadence Design Systems, Inc., San Jose, California) design flow, the capacitance was extracted for the capacitor according to an embodiment of the present disclosure and fringe capacitor described earlier and a fringe capacitor present in the Design Kit. The Design Kit capacitor is often equivalently referred to as the Process Technology Process (PTP) capacitor. For an example process technology, the surface area of the three capacitor types was chosen to be very close to one-another. The fractal capacitor according to the present disclosure has about 3 1 % more capacitance (i.e., the capacitive density, nF/mm², is the greatest) for the given area than that of the Process Technology Package (PTP) structure (i.e., Design Kit capacitor). Refer to Table 1.

| Table 1 Comparison of Capacitor Types | | | | | | | | |
|---|---|---|---|---|---|---|---|---|
| | W(μm) | L(μm) | Area (μm²) | Capacitance (F) | Density (nF/mm²) | Increase w.r.t. PTP cap | Increase w.r.t. ICRF_CAP | Parasitic cap as percentage of total capacitance |
| ICRF_CAP [1] | 31.06 | 30.34 | 942 | 1.69E-12 | 1.80 | 9% | | 2.61% |
| **Fractal (Present Invention)** | **32.1** | **32.1** | **1030** | **2.22E-12** | **2.15** | **31%** | **20%** | **1.83%** |
| PTP | 33.16 | 31.87 | 1057 | 1.7356E-12 | 1.64 | 0% | -9% | 4% |

Refer to Fig. 10. Applying the present invention in an example design process, the user will have designed a particular circuit and put together a schematic with ideal devices 20, the tool will have derived a layout 10 from the schematics 20. Parasitic capacitance, inductance, etc. will be added into the layout 10 and schematic 20. The user would then simulate the circuit design and extract the real capacitance through back annotated simulation 40.

Numerous other embodiments of the invention will be apparent to persons skilled in the art without departing from the spirit and scope of the invention as defined in the appended claims.

**Claims**

1. An integrated circuit, comprising:

   - a first capacitive structure (500) including a first electrode (510) **characterized by** a plurality of series coupled conductive line segments arranged in a fractal pattern in a first layer of the integrated circuit, and a second electrode (520) in the first layer of the integrated circuit, the second electrode having a shape bounded by and conductively isolated from the first electrode.

2. The integrated circuit of claim 1, wherein the fractal pattern(410) is a Hilbert fractal pattern.

3. The integrated circuit of claim 1, wherein the fractal pattern (420, 500) is a third iteration Hilbert fractal pattern.

4. The integrated circuit of claim 1, further comprising:

   - second, third, and fourth capacitive structures identical to the first capacitive structure, the first, second, third and fourth capacitive structures placed in respective lower-right, lower-left, upper-right, and upper left quadrants of a square region of the first layer and coupled in series.

5. The integrated circuit of claim 4, wherein:

   - the first and second capacitive structures are placed in a first orientation;
   - the third capacitive structure is placed in a second orientation rotated 90° counter-clockwise from the first orientation; and
   - the fourth capacitive structure is placed in a third orientation rotated 90° clockwise from the first orientation.

6. The integrated circuit of claim 1, further comprising:

   - a dielectric layer over and adjacent to the first layer;
   - a second capacitive structure identical to the first capacitive structure in a second layer over and adjacent to the dielectric layer, the second capacitive structure placed in a region of the second layer bounded by a projection of the first capacitive structure in an axis tangent to the first and second layers.

7. The integrated circuit of claim 4, wherein:

  - the first capacitive structure is placed in first orientation; and
  - the second capacitive structure is placed in a second orientation different from the first orientation.

8. A Hilbert fractal pattern capacitive structure (410) in an integrated circuit (IC) device, the capacitive structure comprising:

  - a first electrode defined by a Hilbert fractal pattern (420, 425, 430, 440, 450, 460) of at least one iteration; and
  - a second electrode having a shape bounded by and conductively isolated from the first electrode; and
  - the capacitive structure defined by the first and second electrodes.

9. The Hilbert fractal pattern capacitive structure as recited in claim 8, wherein dimensions of the capacitive structures are governed by critical dimensions of the manufacturing process.

10. The Hilbert fractal pattern capacitive structure as recited in claim 9, wherein the at least one iteration is governed by the critical dimensions of the manufacturing process.

11. The Hilbert fractal pattern capacitive structure as recited in claim 8, wherein the at least one iteration is 3.

12. The Hilbert fractal pattern capacitive structure as recited in claim 11, further comprising,

  - a first capacitive structure manufactured on a thin first metal layer at a first orientation;
  - an inter-level dielectric covering the then first metal layer, the inter-level dielectric having vias at a plurality of locations on the first metal layer; and
  - an additional capacitive structure manufactured on an additional thin metal layer at an orientation rotated 90° counter-clockwise with respect to the first orientation, the additional metal layer connected to the first metal layer at the plurality via locations, thereby connecting the first capacitive structure with the additional capacitive structure.

13. A Hilbert fractal capacitor unit cell (800) with a total capacitance, comprising:

  - four Hilbert fractal pattern capacitive structures,
  wherein the fractal capacitive structure (600) includes,

    - a first capacitive structure (M1, M3, M5) manufactured on a thin first metal layer at a first orientation, the Hilbert fractal capacitive structure having,

      - a first electrode defined by a Hilbert fractal pattern of at least one iteration; and
      - a second electrode having a shape bounded by and conductively isolated from the first electrode; and

    - an inter-level dielectric covering the thin first metal layer, the inter-level dielectric having vias at a plurality of locations on the first metal layer; and
    - an additional Hilbert fractal pattern capacitive structure manufactured on an additional thin metal layer (M2, M4) at an orientation rotated 90° counter-clockwise with respect to the first orientation, the additional metal layer connected to the first metal layer at the plurality of via locations, thereby connecting the first capacitive structure with the additional capacitive structure, a total capacitance of the fractal capacitive structure being present at the first electrode and second electrode;

  wherein each fractal capacitive structure (810, 820, 830, 840) is oriented at 0°, 90°, 180°, and 270°, respectively with one another; and
  wherein each oriented fractal capacitive structure is electrically coupled to one another, at the first and second electrodes, respectively, thereby a sum of each of the four fractal capacitive structures is the total capacitance of the unit cell (800).

**14.** The Hilbert fractal capacitor unit cell (800) as recited in claim 13, further comprising,

- a first thick metal layer (M6);
- a second thick metal layer (M7);
- an inter-metal dielectric layer separating the first and second thick metal layer; and

wherein the first and second thick metal layers are coupled together (VIA 7) through vias at selected regions defining the first electrode and second electrode of the Hilbert fractal capacitor unit cell.

**15.** A method of manufacturing an integrated circuit having a Hilbert fractal elementary cell, the method comprising:

- patterning a first Hilbert capacitive structure on a thin first metal layer at a first orientation, the Hilbert fractal pattern capacitive structure having,

- a first electrode defined by a Hilbert fractal pattern of at least one iteration; and
- a second electrode having a shape bounded by and conductively isolated from the first electrode; and
- patterning an inter-level dielectric covering the thin first metal layer, the inter-level dielectric having vias at a plurality of locations on the first metal layer; and
- patterning an additional Hilbert fractal pattern capacitive structure on an additional thin metal layer at an orientation rotated 90° counter-clockwise with respect to the first orientation, the additional metal layer connected to the first metal layer at the plurality via locations, thereby connecting the first capacitive structure with the additional capacitive structure, a total capacitance of the fractal capacitive structure being present at the first electrode and second electrode;

- generating additional Hilbert fractal elementary cells,
wherein each fractal capacitive structure is oriented at 0°, 90°, 180°, and 270°, respectively with one another; and
wherein each oriented fractal capacitive structure is electrically coupled to one another, at the first and second electrodes, respectively, thereby generating a Hilbert fractal capacitor unit cell with a total capacitance being the sum of each of the four fractal capacitive structures.

**FIG. 1**

$$C = \frac{\varepsilon_r * S}{e}$$

400

1ST ITERATION

2ND ITERATION

410

420

410

425

3RD ITERATION

4TH ITERATION

410

430

440

5TH ITERATION

6TH ITERATION AT 4X

450

460

FIG. 2

FIG. 3

FIG. 4

EP 2 413 347 A1

<u>700</u>

730

720

710

FIG. 5

FIG. 6

FIG. 7

FIG. 8

SWITCH-ABLE FRACTAL CAP USED IN DIFFERENTIAL MODE

DIFFERENTIAL IN

DIFFERENTIAL OUT

FIG. 9

FIG. 10

Europäisches
Patentamt
European
Patent Office
Office européen
des brevets

**PARTIAL EUROPEAN SEARCH REPORT**

under Rule 62a and/or 63 of the European Patent Convention.
This report shall be considered, for the purposes of
subsequent proceedings, as the European search report

Application Number

EP 10 29 0414

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GIMENO C ET AL: "Hilbert Curve Based Lateral Flux Capacitors", ELECTRON DEVICES, 2009. CDE 2009. SPANISH CONFERENCE ON, IEEE, PISCATAWAY, NJ, USA, 11 February 2009 (2009-02-11), pages 219-222, XP031436608, ISBN: 978-1-4244-2838-0 | 1-3 | INV. H01L21/02 H01L23/522 H01L27/02 |
| A | * abstract; figures 4,5,8 * * Chapters II. and III.; page 220 - page 221 * ----- | 4-7,15 | |
| X | US 2008/011509 A1 (BALIARDA CARLES P [ES] ET AL PUENTE BALIARDA CARLES [ES] ET AL) 17 January 2008 (2008-01-17) * abstract; figures 1,2.10,9 * * paragraphs [0063] - [0078], [0085] * ----- -/-- | 1-7,15 | |

TECHNICAL FIELDS SEARCHED (IPC)

H01L

### INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 20 January 2011 | Mosig, Karsten |

PARTIAL EUROPEAN SEARCH REPORT

Application Number

EP 10 29 0414

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| X | HIRAD SAMAVATI ET AL: "Fractal Capacitors", IEEE JOURNAL OF SOLID-STATE CIRCUITS, IEEE SERVICE CENTER, PISCATAWAY, NJ, US, vol. 33, no. 12, 1 December 1998 (1998-12-01), XP011060899, ISSN: 0018-9200 | 1 | |
| A | * the whole document * ----- | 2-7,15 | |
| X | MOSELHY T ET AL: "Investigation of space filling capacitors", MICROELECTRONICS, 2003. ICM 2003. PROCEEDINGS OF THE 15TH INTERNATIONA L CONFERENCE ON CAIRO, EGYPT DEC. 9-11, 2003, PISCATAWAY, NJ, USA,IEEE, 9 December 2003 (2003-12-09), pages 287-290, XP010697473, ISBN: 978-977-05-2010-9 | 1-3 | **TECHNICAL FIELDS SEARCHED** (IPC) |
| A | * the whole document * ----- | 4-7,15 | |

EPO FORM 1503 03.82 (P04C10)

Europäisches
Patentamt

European
Patent Office

Office européen
des brevets

**INCOMPLETE SEARCH
SHEET C**

Claim(s) completely searchable:
    1-7, 15

Claim(s) not searched:
    8-14

Reason for the limitation of the search:

In the letter of reply to the invitation pursuant to Rule 62a(1) EPC, the applicant has indicated that separate searches should be made for each independent device claim. Rule 62a EPC, however, does not present any possibility to establish more than one search report. Thus, the search report has been drawn up on the basis of the first independent claim of each category (Rule 62a(1) EPC, last sentence).

## ANNEX TO THE EUROPEAN SEARCH REPORT
## ON EUROPEAN PATENT APPLICATION NO.

EP 10 29 0414

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2011

| Patent document cited in search report | | Publication date | Patent family member(s) | | Publication date |
|---|---|---|---|---|---|
| US 2008011509 | A1 | 17-01-2008 | AU | 2439200 A | 31-07-2001 |
| | | | BR | 0017066 A | 03-12-2002 |
| | | | CN | 1434988 A | 06-08-2003 |
| | | | WO | 0154221 A1 | 26-07-2001 |
| | | | EP | 1269562 A1 | 02-01-2003 |
| | | | EP | 2051325 A1 | 22-04-2009 |
| | | | JP | 2003520542 T | 02-07-2003 |
| | | | US | 7245196 B1 | 17-07-2007 |

EPO FORM P0459

For more details about this annex : see Official Journal of the European Patent Office, No. 12/82